# EUROPEAN PATENT APPLICATION

(11) **EP 2 712 089 A1**
(43) Date of publication of application: **26.03.2014**
(21) Application number: 12290309.9
(22) Date of filing: 20.09.2012
(51) Int. Cl.: H03M 7/30

(54) **Method for compressing texts and associated equipment**

(71) Applicant: Alcatel Lucent, 75007 Paris (FR)
(72) Inventor: Denhez, Alain, 78141 Velizy (FR)
(74) Representative: Croonenbroek, Thomas Jakob

(57) **Abstract**

The present invention refers to a method for compressing an input stream of text characters into an output stream of compressed codes, the said method comprising the steps of:
- providing a first conversion table between selected character strings having a predetermined number of characters higher than one and compressed codes, the number of character strings in the first conversion table being limited to a predetermined number so that the number of bits for encoding the said character strings is smaller than the number of bits for encoding the characters of the string individually,
- providing at least one second conversion table between predetermined character strings having a number of characters smaller than the predetermined number of characters of the first conversion table and compressed codes,
- dividing the input stream into character strings having the predetermined number of characters and extracting the said character strings,
- if an extracted character string is stored in the first conversion table, encoding the said extracted character string into compressed codes according to the said first conversion table,
- otherwise dividing the extracted character string into shorter character strings that are stored in the at least one second conversion table and encoding the said shorter character strings into compressed codes according to the at least one second conversion table wherein the character strings selected to establish the first conversion table correspond to the most frequent combinations of character strings in the language of the input streams.

## Description

### BACKGROUND OF THE INVENTION

The present invention relates to the field of data compression. With the development and the popularisation of telecommunication means, the amount of exchanged data is always increasing and the operators have to cope with this increasing amount of data. Two solutions appears to solve this problem, on one side, the operators can improve the throughput of the networks and, on the other side, they can improve the coding of the data to obtain better compression rates. Indeed, this last solution appears to be easier and cheaper to implement. One well-known coding for the Latin alphabet is the American Standard Code for Information Interchange (ASCII) coding wherein each character is coded with 8 bits (in the case of extended ASCII code). Thus, many compression techniques have been developed in the state of the art to provide a higher compression rate than the ASCII code. However, the difficulty is that these techniques either applied on a limited number of characters or require long and cumbersome computations to analyse the features of data needed to be encoded.

### SUMMARY OF THE INVENTION

It is therefore an object of the present invention to overcome the above mentioned drawbacks of the state of the art and to provide a solution for improving the compression rate of encoded text message that is easy to implement.

Thus, the present invention refers to a method for compressing an input stream of text characters into an output stream of compressed codes, the said method comprising the steps of:
- providing a first conversion table between selected character strings having a predetermined number of characters higher than one and compressed codes, the number of character strings in the first conversion table being limited to a predetermined number so that the number of bits for encoding the said character strings is smaller than the number of bits for encoding the characters of the string individually,
- providing at least one second conversion table between predetermined character strings having a number of characters smaller than the predetermined number of characters of the first conversion table and compressed codes,
- dividing the input stream into character strings having the predetermined number of characters and extracting the said character strings,
- if an extracted character string is stored in the first conversion table, encoding the said extracted character string into compressed codes according to the said first conversion table,
- otherwise dividing the extracted character string into shorter character strings that are stored in the at least one second conversion table and encoding the said shorter character strings into compressed codes according to the at least one second conversion table wherein the character strings selected to establish the first conversion table correspond to the most frequent combinations of character strings in the language of the input streams.

According to another aspect of the invention, the establishment of the first conversion table comprises a step of analysing texts of the language of the input streams.

According to a further aspect of the invention, the space and/or the punctuation are considered as character.

According to an additional aspect of the invention, the first conversion table comprises combinations of alphabet characters and space characters.

According to another aspect of the present invention, the first conversion table comprises combinations of alphabet characters and punctuation characters.

According to a further aspect of the invention, the predetermined number of characters of the first conversion table is two.

According to an additional aspect of the invention, the input streams comprise Latin alphabet characters and wherein the number of combinations of character pairs is limited to five hundred and twelve and wherein a pair is coded by a twelve bit code, one bit to indicate that the code refers to a pair, two bits for coding the case state of the characters and nine bits for coding the five hundred and twelve combinations of the established conversion table whereas a single character is coded with a nine bit code, one bit to indicate that the code refers to a single character and eight bits for coding the combinations of characters of the provided conversion table.

According to another aspect of the invention, the provided conversion table is an American Standard Code for Information Interchange "ASCII" conversion table.

The embodiments of the present invention also refer to a method for decompressing a received stream of compressed codes into a stream of text characters, the said method comprising the recursive steps of:
- scanning the next bit,
   if the scanned bit corresponds to a pair coding,
   - storing the next two bits as case letter for the first and second characters,
   - comparing the next nine bits with the code stored in a first conversion table,
   - decoding the nine bit code into a pair of character according to the first conversion table,
   - applying the case letter to the first and the second decoded characters according to the stored case letters,
   if the scanned bit corresponds to a single character coding,
   - comparing the next eight bits with the codes stored in a second conversion table,
   - decoding the eight bit code into a character according to the second conversion table

The embodiments of the present invention also refer to a data compression equipment comprising:
- storing means configured for storing conversion tables between character strings and compressed codes,
- at least one processing mean configured for:
   - receiving an input stream of data,
   - dividing an input stream into character strings having a predetermined number of characters higher than one,
   - extracting the said character strings,
   - comparing the extracted character strings with the character strings of the conversion tables,
   - encoding the extracted character strings according to the stored conversion tables if a stored conversion table comprises the extracted character string,
   - dividing the character string into shorter character strings that are stored in a conversion table and encoding the shorter character string according to the conversion table otherwise.

According to another embodiment, the at least one processing mean is also configured for:
- scanning data,
- selecting a predetermined number of character strings corresponding to the most frequent combinations of character strings of a predetermined number of characters in the scanned data,
- establishing a conversion table by associating the selected character strings to respective compressed codes.

According to a further embodiment, the at least one processing mean is also configured for:
- receiving a stream of compressed codes,
   recursively until the end of the stream:
   - scanning the next bit
   if the scanned bit corresponds to a pair coding,
   - storing the next two bits as case letter for the first and second characters,
   - comparing the next nine bits with the code stored in a first conversion table,
   - decoding the nine bit code into a pair of character according to the first conversion table,
   - applying the case letter to the first and the second decoded characters according to the stored case letters,
   if the scanned bit corresponds to a single character coding,
   - comparing the next eight bits with the codes stored in a second conversion table,
- decoding the eight bit code into a character according to the second conversion table.

### BRIEF DESCRIPTION OF THE DRAWINGS

FIG.**1** is a flowchart of the different steps of the method according to an embodiment of the present invention;
FIG.**2** is a diagram of a conversion table comprising a correspondence between pairs of characters and hexadecimal codes;
FIG.**3** is a diagram of an ASCII conversion table comprising a correspondence between characters and hexadecimal codes;
FIG.**4** is a diagram of an extended ASCII conversion table comprising a correspondence between characters and hexadecimal codes;
FIG.**5** is a diagram of a transmission of a compressed message from a first to a second user equipment.

### DETAILED DESCRIPTION OF THE INVENTION

As used herein, the term "ASCII" refers to the acronym American Standard Code for Information Interchange.

The embodiments of the present invention refer to a method for compressing an input stream of text characters, for example a message such as a short message system (SMS) or an electronic mail, into an output stream of compressed codes, generally a binary code, wherein the coding of the characters of the input stream is achieved by coding character strings or blocks of characters comprising at least two characters, the number of bits necessary for coding these character strings being less than the number of bits necessary for coding separately the characters of the character strings.

In the following of the description, the described embodiments will be limited to character strings of two characters. However, it has to be noted that the method disclosed herein may also be applied to character strings having a higher number of characters.

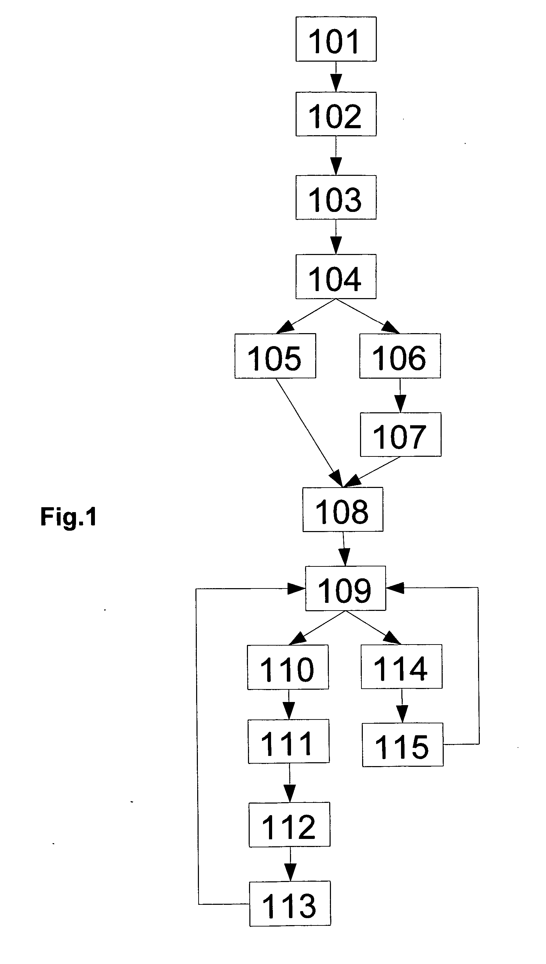

Fig.1 represents a flowchart of the different steps of the method.

The first two steps 101 and 102 refer to preliminary steps that need to be achieved before starting an actual compression of an input stream. Furthermore, if the type of text, for example the language, is always the same for the different input streams, these preliminary steps may be achieved only once and then the conversion tables obtained with these steps can be used for any compression of an input stream for which the conversion tables are relevant (same language for example).

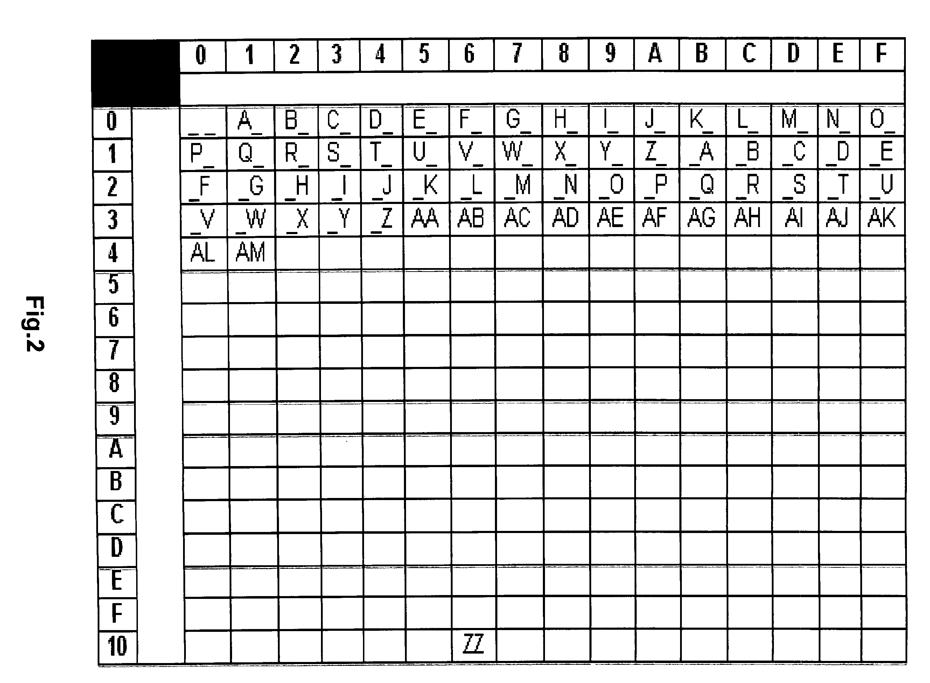

The first step 101 refers to the provision of a first conversion table between selected pairs of characters and compressed codes. The space character and the punctuation may be considered as characters and can be encoded within pair of the first conversion table, for example a pair can comprise an "A" and a space and another can comprise an "N" and a coma ",". In order to limit the number of bits required for coding the pairs of characters, only a predetermined number of selected pairs is used in the conversion table. This predetermined number is advantageously a power of 2, for example 2⁹=512. Indeed, if we consider input streams comprising text written in English with only the alphabetic characters and the space character (i.e. without punctuation), the possible number of combinations of pairs is 28*26=728. However, some of these combinations are almost never used, for example the pair "yy". Thus, by scanning texts representative of the vocabulary of the input streams, one can determine which combinations are relevant and can select the most relevant combinations. For example by scanning an English dictionary or long English texts, one can observe that less than 512 are effectively used in most texts. The number of pair combinations in the conversion table can therefore be limited to 512 in the case of coding of messages comprising only letters and spaces. Using a reduced number of combinations enables to reduce the number of bits required for the coding of a pair which requires therefore less bits that the coding of two characters separately using the ASCII code. Fig.2 represents an example of a conversion table comprising pairs of spaces and upper case Latin letters. The space character is represented by the underscore character "_" in fig.2. The conversion table is presented in the same way as an ASCII conversion table with 16 columns numbered in a hexadecimal base or base 16 and rows also numbered in a hexadecimal base. With this coding the pair AA corresponds to the code 035 and the pair ZZ to the code 106. It has also to be noted that even if the coding of the conversion table in Fig.2 is shown in a hexadecimal base, in practise the coding has to be made in a binary base so that either the conversion table comprises binary codes or a conversion is applied from the hexadecimal base to the binary base to obtain the binary compressed codes. The hexadecimal code 035 would therefore be converted in the binary code 110101. Zeros can be added in front of the binary number to match with the requested number of bits.

Thus, the conversion table comprises only upper letters and two additional bits are used for coding the case letter (upper case or lower case) of the first and the second letters of the pair.

Such conversion table can be established using a data compression equipment comprising processing means such as a microprocessor configured for scanning a text, for counting the number of appearances of each pair and for establishing the conversion table using the most frequent pairs, the number of pairs of the conversion table being determined either automatically based on the number of pairs encountered during the scanning or given by the user. The data compression equipment also comprises storing means such as a read-only memory (ROM) for storing the conversion table.

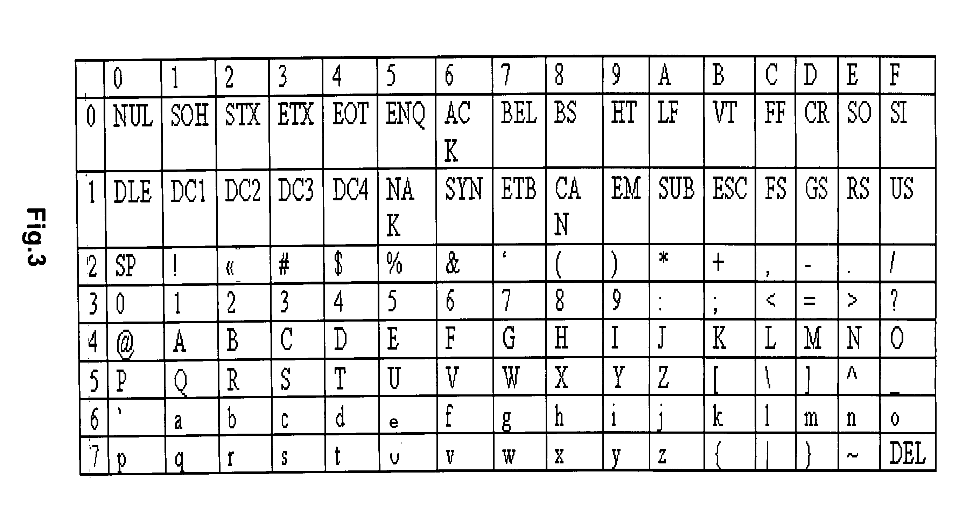

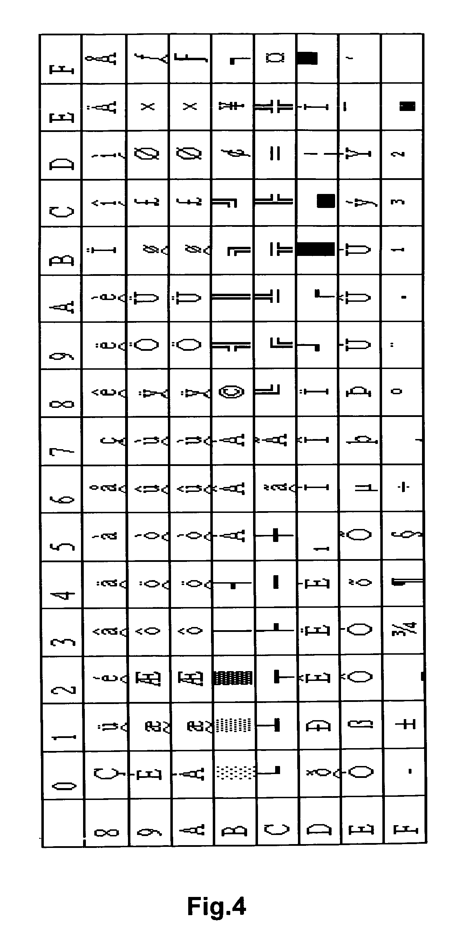

The second step 102 refers to the provision of a second conversion table of character strings having less characters than the character strings of the first conversion table. As in the present case, the first conversion table comprises character strings of two characters, the second conversion table is composed of character strings comprising single characters. Thus, such conversion table may refer to a classical ASCII conversion table as shown in Fig.3. ASCII tables are conversion tables from the International standard Organization (ISO) and are available for a plurality of languages. The ASCII conversion table used herein comprises 16 columns numbered in a hexadecimal base and 8 rows for the main ASCII table and 8 more rows for the extended ASCII table represented in Fig.4. The number of columns and rows is chosen to match with the keys of a keyboard. As described previously, the first conversion table comprises only a limited number of combinations corresponding to the pairs having the highest probability to appear in an input stream needing to be coded so that single characters need also to be coded in case a pair of characters is not registered in the first conversion table. Indeed, if a pair of characters is not coded in the first conversion table, the characters of the pair are then coded separately using the second conversion table. Furthermore, an additional bit is required to distinguish between the coding of a pair and the coding of a signal character. As a consequence, the coding of a single character requires 9 bits (8 bits for a classical ASCII character (1 bit to distinguish between the main and the extended ASCII tables and 7 bits for coding the character with one of the table + 1 bit to define the coding of a single character) and a pair of characters require 12 bits (9 bits for coding the pair in the first conversion table + 2 bits for coding the case letter + 1 bit to define the coding of a pair). The second conversion table is also stored in the storing means of the compression data equipment.

The first and second conversion tables are then transmitted to the different data compression equipments that need to exchange messages encoded according to the embodiments of the present invention, for example the different user equipments of a network. The conversion tables may also be stored in a server so that the different user equipments connected to the server have access to the conversion tables. Different conversion tables may be defined for different types of text, for example one conversion table for each language.

The third step 103 refers to the division of an input stream needing to be compressed into pairs of characters or blocks of two characters and also refers to the extraction of the pairs or blocks. The input stream is sent to the processing means and the division is achieved such that one character belongs to only one pair and such that two characters of a pair are consecutive characters. As a consequence, the first pair is constituted by first two characters of a message, the second pair by the next two characters of the message and so on until the end of the message. In the case of an input stream having more than three characters, this division leads to a plurality of pairs and possibly to a single character in case of an input stream having an odd number of characters. The pairs and possible single character are then extracted to be processed separately.

The fourth step 104 refers to the comparison by the processing means of the extracted pairs of characters with the pairs stored in the first conversion table. This step may also comprise additional steps of storage of the case letter of each character of the pair and conversion of the said characters of the pair into a predefined case letter, for example into upper case in the present case in order to match with the case letter of the first conversion table.

If the extracted pair matches with a pair of the first conversion table, the said extracted pair is then encoded in a fifth step 105 according to the compressed code associated with this pair in the first conversion table. The case letter of each character of the pair is coded separately from the coding of the pair based on the conversion table. As a consequence, a pair of characters is coded in three parts according to the following scheme _/_ _/_ _ _ _ _ _ _ _ _ with the first bit set, for example, to 1 to indicate that the coding refers to a pair of characters, the next two bits to indicate the case letter of the first and the second characters, for example 0 may refer to a lower case and 1 to an upper case, and the next nine bits for coding the pair in a binary code according to the first conversion table. It has to be noted that the order of the two bits coding for the case letter and the nine bits coding for the pair of characters can be switched, however, the first bit indicating the coding of a pair has to remain in first position in the coding.

If the extracted pair does not match with any of the pairs stored in the first conversion table, the pair is divided into two single characters in a step 106 and the single characters are encoded separately using the second conversion table in a step 107. The coding is then achieved in three part according to the following scheme _/_/ _ _ _ _ _ _ _ with the first bit set, for example, to 0 to indicate the coding of a single character, one bit to indicate if the coding refers to the main or to the extended ASCII conversion table and the next seven bits for coding the character in a binary code according to one of the second conversion table (among the two, i.e. the main and the extended ASCII conversion tables). The first character is compared with the characters stored in the second conversion table and the first character is then encoded according to the corresponding compressed code by the processing means. In the same way, the second character is also encoded. As the second conversion table comprises all the characters, any character can be encoded based on the second conversion table.

Thus, as the first conversion table comprises most of the pair combinations, most of the pairs of a text can be encoded using the first conversion table and only a few pairs need to be encoded using the second conversion table so that the total number of bits required for encoding a text remain smaller than the number of bits required for encoding the same text based only on a single character coding.

Step 108 refers to the transmission of the stream of compressed codes. When the coding of the initial text into binary compressed codes is achieved, the binary compressed codes are concatenated in strings to produce a stream. The stream is then sent to its destination for example through a communication network.

At destination, the received stream of compressed codes are then decompressed using a data compression equipment. The decompression is achieved by applying the following steps:
Step 109 refers to the scanning of the next bit which is the first bit at the beginning of the decompression. If the scanned bit corresponds to a pair coding, i.e. if the bit is 1 in the present case, the pair of characters is decompressed according to the steps 110 to 113 and if the scanned bit corresponds to a single character coding, the character is decoded according to steps 114 to 115.
Step 110 refers to the storage of the next two bits as case letter for the first and the second characters in data storage such as a RAM or ROM memory.
Step 111 refers to the comparison of the next nine bits with the codes stored in the first conversion table to retrieve the nine bit code and the associated pair of character.
Step 112 refers to the decoding of the nine bit code into a pair of characters according to the first conversion table.
Step 113 refers to the application of the case letter to the first and the second characters according to the case letter coding stored in step 110. Indeed, as in the first conversion table, the case letter is not taken into account but is encoded separately during the encoding, the encoded character have first to be retrieved and then the initial case letter has to be applied according to the coding part dedicated to the case letter. The initial pair of characters is then recovered so that the method goes back to step 109 until the whole received stream is decompressed.
Step 114 refers to the comparison of the next eight bits with the codes stored in the second conversion table to retrieve the eight bit code and the associated character.
Step 115 refers to the decoding of the eight bit code into a character according to the second conversion table. The initial character is then recovered so that the method goes back to step 109 until the whole received stream is decompressed.

The steps of the method disclosed herein may be implemented through or together with a software program written in e.g. very high speed integrated circuit hardware description language (VHDL) or C, C++, Java or using another programming language or implemented by one or more VHDL, C, C++ or Java processes or routines or several software modules being executed on at least one hardware device or computer program apparatus. The programmable device and processing means can be any kind of device which can be programmed including e.g. any kind of computer like a server or a personal computer, a field programmable gate array (FPGA), a processor or the like or any combination thereof, e.g. one processor and two FPGAs.

The storage means could be any kind of data repository in any storage medium such as a compact disc (CD) or disk, e.g. universal serial bus (USB) memory stick or any kind of memory, e.g. at least one RAM or ROM or the like or any combination thereof, e.g. one ROM and two RAMs or two disks...

The software program used to implement the steps of the method is a set of instructions which could be created using Java, C, C++, hypertext markup language (html), Lisp or another programming language.

In order to better understand the embodiments of the present invention an example will now be described.

The method is implemented in a communication network in the exchange of messages between the different user equipments and is based on the conversion tables presented in fig.2 , 3 and 4 such that the user equipments of the network have access to these tables. These conversion tables may either be stored in the user equipments themselves or stored on a server accessible by the user equipments.

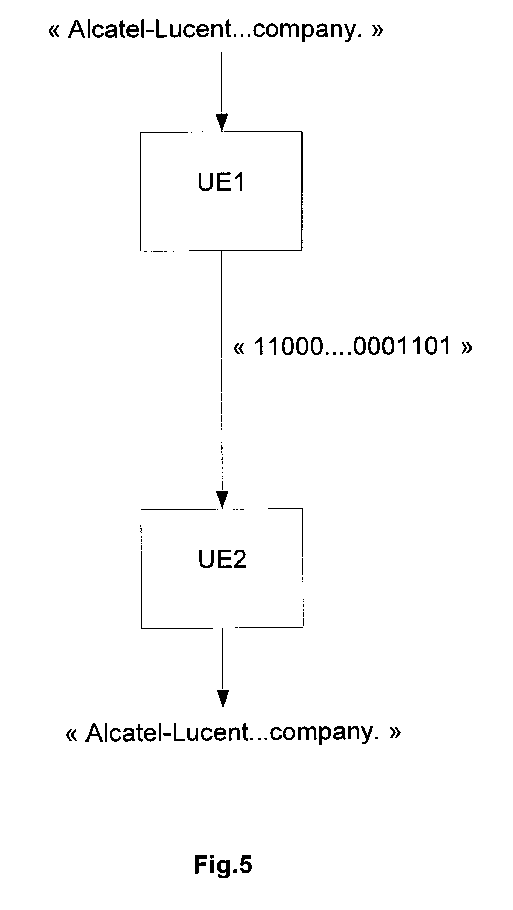

A message needs to be sent from a first user equipment UE1 to a second user equipment UE2 as represented in Fig.5. Both user equipments are equipped with a data compression equipment, for example a dedicated software or application executed by the microprocessor of the user equipments. Furthermore, the first and the second conversion tables are stored in the memory of both user equipments. The message needing to be sent by the first user equipment corresponds to the following text:
"Alcatel-Lucent is a great company."

Thus, the text is first divided into pairs of characters using the data compression equipment implemented in the first user equipment UE1 so that the obtained pairs of characters are:
Al / ca / te / l- / Lu / ce / nt / _i / s_ / a_ / gr / ea / t_ / co / mp / an / y.
with the underscore "_" representing the space character.

The first pair "Al" is then processed. The case letter is stored so that the bits for the case letters are respectively 1 and 0 (1 corresponding to an upper case and 0 to a lower case). The character are then converted into upper case (AL) and compared with the pairs of characters stored in the first conversion table. The pair AL corresponds to the hexadecimal code 40 which is converted into a nine bit binary code "001000000" then the case letter bits are added by string concatenation to get the eleven bit code: "10001000000" and finally the bit indicating the type of coding (here 1 corresponds to a pair coding and 0 to a single character coding) is added by string concatenation to get the twelve bit code: "110001000000". The next pairs "ca" and "te" are then processed in the same way. For the pair "1-", as this pair is not in the first conversion table, the comparison with the first conversion table does not lead to any compressed code. Thus, the pair is divided into two single characters "1" and "-" which are then encoded according to the second conversion table. The character "1" corresponds to the hexadecimal code 6C in the main ASCII table which corresponds to the binary code 0 1101100 and the character "-" corresponds to the hexadecimal code 2D in the main ASCII table which corresponds to the binary code 0 0101101. In the same way, the pair "y." is also divided into two single characters whereas the other pairs are encoded according to the first conversion table.

As a consequence, the stream of compressed code corresponds to a stream of 12 bits * 15 pairs + 9 bits * 4 single characters = 216 bits (instead of 8 bits * 34 characters = 272 bits with the ASCII single character coding, i.e. a gain of approximately 20% in the compression rate) that can be sent through the network to the second user equipment UE2. A header of a predetermined format comprising, for example the address of the second user equipment is generally added at the beginning of the stream of compressed codes and the transmission is achieved for example using modulation techniques known in the state of the art.

At the reception by the second user equipment UE2, the signal is demodulated, the stream of compressed codes is retrieved and can be decompressed. The decompression starts by analysing the first bit, in the present case a "1", which indicates that the coding corresponds to a pair of characters. The next two characters "10" corresponding to the case letter of both characters are stored. The next nine bits are then compared with the codes of the first conversion table. In the present case, a conversion from binary to hexadecimal is first achieved. The corresponding pair of characters is then retrieved, "AL" in the present case and the stored case letters are applied so that the obtained pair of characters is "Al". The whole stream of compressed code is then processed and the retrieved characters are then concatenated in string to retrieve the initial text: "Alcatel-Lucent is a great company.".

Thus, the text compression coding based on pairs of characters according to the embodiments of the present invention enables in most cases a compression of a stream of text characters having a compression rate higher than the ASCII compression method without requiring expensive equipments and based on a simple algorithm. Furthermore, the method can be achieved on any text based on the Latin alphabet. Indeed, a simple adaptation of the first conversion table enables to optimize the method for a given language. For example, an English dictionary can be used to set up a conversion table aimed at being used for English texts while a French dictionary can be used for set up a conversion table used for French texts.

Besides, as noticed previously the compression technique described herein can also be applied to longer strings of characters. For example, a conversion table comprising the most common triplets of characters can be set up and used. In this case, if a triplet of a text is not stored in the first conversion table comprising triplets of characters, the triplet is divided into a pair and a single character that are processed with associated conversion tables of pairs and single characters.

## Claims

1. Method for compressing an input stream of text characters into an output stream of compressed codes, the said method comprising the steps of:
- providing (101) a first conversion table between selected character strings having a predetermined number of characters higher than one and compressed codes, the number of character strings in the first conversion table being limited to a predetermined number so that the number of bits for encoding the said character strings is smaller than the number of bits for encoding the characters of the string individually,
- providing (102) at least one second conversion table between predetermined character strings having a number of characters smaller than the predetermined number of characters of the first conversion table and compressed codes,
- dividing (103) the input stream into character strings having the predetermined number of characters and extracting the said character strings,
- if an extracted character string is stored in the first conversion table, encoding (105) the said extracted character string into compressed codes according to the said first conversion table,
- otherwise dividing (106) the extracted character string into shorter character strings that are stored in the at least one second conversion table and encoding (107) the said shorter character strings into compressed codes according to the at least one second conversion table wherein the character strings selected to establish the first conversion table correspond to the most frequent combinations of character strings in the language of the input streams.

2. Method in accordance with claim 1 wherein the establishment of the first conversion table comprises a step of analysing texts of the language of the input streams.

3. Method in accordance with claim one of the previous claims wherein the space and/or the punctuation are considered as character.

4. Method in accordance with one of the previous claims combined with claim 3 wherein the first conversion table comprises combinations of alphabet characters and space characters.

5. Method in accordance with claim 3 or 4 wherein the first conversion table comprises combinations of alphabet characters and punctuation characters.

6. Method in accordance with one of the previous claims wherein the predetermined number of characters of the first conversion table is two.

7. Method in accordance with claim 6 wherein the input streams comprise Latin alphabet characters and wherein the number of combinations of character pairs is limited to five hundred and twelve and wherein a pair is coded by a twelve bit code, one bit to indicate that the code refers to a pair, two bits for coding the case state of the characters and nine bits for coding the five hundred and twelve combinations of the established conversion table whereas a single character is coded with a nine bit code, one bit to indicate that the code refers to a single character and eight bits for coding the combinations of characters of the provided conversion table.

8. Method in accordance with one of the previous claims wherein the provided conversion table is an American Standard Code for Information Interchange "ASCII" conversion table.

9. Method for decompressing a received stream of compressed codes encoded according to claim 7 or 8 into a stream of text characters, the said method comprising the recursive steps of:
- scanning (109) the next bit,
if the scanned bit corresponds to a pair coding,
- storing (110) the next two bits as case letter for the first and second characters,
- comparing (111) the next nine bits with the code stored in a first conversion table,
- decoding (112) the nine bit code into a pair of character according to the first conversion table,
- applying (113) the case letter to the first and the second decoded characters according to the stored case letters,
if the scanned bit corresponds to a single character coding,
- comparing (114) the next eight bits with the codes stored in a second conversion table,
- decoding (115) the eight bit code into a character according to the second conversion table

10. Data compression equipment comprising
- storing means configured for storing conversion tables between character strings and compressed codes,
- at least one processing mean configured for:
- receiving an input stream of data,
- dividing an input stream into character strings having a predetermined number of characters higher than one,
- extracting the said character strings,
- comparing the extracted character strings with the character strings of the conversion tables,
- encoding the extracted character strings according to the stored conversion tables if a stored conversion table comprises the extracted character string,
- dividing the character string into shorter character strings that are stored in a conversion table and encoding the shorter character string according to the conversion table otherwise.

11. Data compression equipment in accordance with claim 10 wherein the at least one processing mean is also configured for:
- scanning data,
- selecting a predetermined number of character strings corresponding to the most frequent combinations of character strings of a predetermined number of characters in the scanned data,
- establishing a conversion table by associating the selected character strings to respective compressed codes.

12. Data compression equipment in accordance with claim 10 or 11 wherein the at least one processing mean is also configured for:
- receiving a stream of compressed codes,
recursively until the end of the stream:
- scanning the next bit
if the scanned bit corresponds to a pair coding,
- storing the next two bits as case letter for the first and second characters,
- comparing the next nine bits with the code stored in a first conversion table,
- decoding the nine bit code into a pair of character according to the first conversion table,
- applying the case letter to the first and the second decoded characters according to the stored case letters,
if the scanned bit corresponds to a single character coding,
- comparing the next eight bits with the codes stored in a second conversion table,
- decoding the eight bit code into a character according to the second conversion table.

## Amended claims

### Amended claims in accordance with Rule 137(2) EPC.

**1.** Method for compressing an input stream of text characters into an output stream of compressed codes, the said method comprising the steps of:
- providing (101) a first conversion table between selected character strings having a predetermined number of characters higher than one and compressed codes, the number of character strings in the first conversion table being limited to a predetermined number so that the number of bits for encoding the said character strings is smaller than the number of bits for encoding the characters of the string individually,
- providing (102) at least one second conversion table between predetermined character strings having a number of characters smaller than the predetermined number of characters of the first conversion table and compressed codes,
- dividing (103) the input stream into character strings having the predetermined number of characters and extracting the said character strings,
- if an extracted character string is stored in the first conversion table, encoding (105) the said extracted character string into compressed codes according to the said first conversion table,
- otherwise dividing (106) the extracted character string into shorter character strings that are stored in the at least one second conversion table and encoding (107) the said shorter character strings into compressed codes according to the at least one second conversion table wherein the character strings selected to establish the first conversion table correspond to the most frequent combinations of character strings in the language of the input streams wherein the establishment of the first conversion table comprises a step of analysing texts of the language of the input streams..

**2.** Method in accordance with claim one of the previous claims wherein the space and/or the punctuation are considered as character.

**3.** Method in accordance with one of the previous claims combined with claim 3 wherein the first conversion table comprises combinations of alphabet characters and space characters.

**4.** Method in accordance with claim 2 or 3 wherein the first conversion table comprises combinations of alphabet characters and punctuation characters.

**5.** Method in accordance with one of the previous claims wherein the predetermined number of characters of the first conversion table is two.

**6.** Method in accordance with claim 5 wherein the input streams comprise Latin alphabet characters and wherein the number of combinations of character pairs is limited to five hundred and twelve and wherein a pair is coded by a twelve bit code, one bit to indicate that the code refers to a pair, two bits for coding the case state of the characters and nine bits for coding the five hundred and twelve combinations of the established conversion table whereas a single character is coded with a nine bit code, one bit to indicate that the code refers to a single character and eight bits for coding the combinations of characters of the provided conversion table.

**7.** Method in accordance with one of the previous claims wherein the provided conversion table is an American Standard Code for Information Interchange "ASCII" conversion table.

**8.** Method for decompressing a received stream of compressed codes encoded according to claim 6 or 7 into a stream of text characters, the said method comprising the recursive steps of:
- scanning (109) the next bit,
if the scanned bit corresponds to a pair coding,
- storing (110) the next two bits as case letter for the first and second characters,
- comparing (111) the next nine bits with the code stored in a first conversion table,
- decoding (112) the nine bit code into a pair of character according to the first conversion table,
- applying (113) the case letter to the first and the second decoded characters according to the stored case letters,
if the scanned bit corresponds to a single character coding,
- comparing (114) the next eight bits with the codes stored in a second conversion table,
- decoding (115) the eight bit code into a character according to the second conversion table

**9.** Data compression equipment comprising
- storing means configured for storing conversion tables between character strings and compressed codes,
- at least one processing mean configured for:
- receiving an input stream of data,
- dividing an input stream into character strings having a predetermined number of characters higher than one,
- extracting the said character strings,
- comparing the extracted character strings with the character strings of the conversion tables,
- encoding the extracted character strings according to the stored conversion tables if a stored conversion table comprises the extracted character string,
- dividing the character string into shorter character strings that are stored in a conversion table and encoding the shorter character string according to the conversion table otherwise wherein the establishment of a conversion table stored in the storing means comprises a step of analysing texts of the language of the input stream.

**10.** Data compression equipment in accordance with claim 9 wherein the at least one processing mean is also configured for:
- scanning data,
- selecting a predetermined number of character strings corresponding to the most frequent combinations of character strings of a predetermined number of characters in the scanned data,
- establishing a conversion table by associating the selected character strings to respective compressed codes.

**11.** Data compression equipment in accordance with claim 9 or 10 wherein the at least one processing mean is also configured for:
- receiving a stream of compressed codes,
recursively until the end of the stream:
- scanning the next bit
if the scanned bit corresponds to a pair coding,
- storing the next two bits as case letter for the first and second characters,
- comparing the next nine bits with the code stored in a first conversion table,
- decoding the nine bit code into a pair of character according to the first conversion table,
- applying the case letter to the first and the second decoded characters according to the stored case letters,
if the scanned bit corresponds to a single character coding,
- comparing the next eight bits with the codes stored in a second conversion table,
- decoding the eight bit code into a character according to the second conversion table.
